# EUROPEAN PATENT APPLICATION

(11) **EP 4 818 379 A1**
(43) Date of publication of application: **07.10.2026**
(21) Application number: 24922813.1
(22) Date of filing: 06.02.2024
(51) Int. Cl.: C30B 15/20, C30B 19/10, C30B 23/00, C30B 35/00, G06F 30/23, G06F 30/27, G06N 20/20, G06N 3/044, G06N 3/0464, G06N 3/092, G06F 111/10, G06F 119/08

(54) **CRYSTAL GROWTH METHOD AND SYSTEM, APPARATUS, AND STORAGE MEDIUM**

(71) Applicant: BOYA ADVANCED MATERIALS CO., LTD., Meishan, Sichuan 620010 (CN)
(72) Inventor: WANG, Yu, Meishan, Sichuan 620010 (CN); LEI, Pei, Meishan, Sichuan 620010 (CN)
(74) Representative: Wang, Bo
(86) International application number: PCT/CN2024/076441
(87) International publication number: WO 2025/166570

(57) **Abstract**

A method for crystal growth, a system for crystal growth, a crystal growth apparatus, and a storage medium are provided. The method for crystal growth includes: determining a parameter set for the crystal growth apparatus in a target batch, wherein the parameter set comprises at least one target parameter, and wherein the target parameter refers to a parameter that affects crystal growth in the crystal growth apparatus; obtaining a first temperature detection value of a first temperature measuring point of the crystal growth apparatus during a target time period of the target batch; and based on the target parameter and the first temperature detection value, determining a simulated crystal surface temperature corresponding to the first temperature detection value by using a crystal surface temperature determination model.

## Description

### TECHNICAL FIELD

The present disclosure relates to the field of crystal preparation, and in particular to a method, system, apparatus, and non-transitory computer-readable storage medium for crystal growth.

### BACKGROUND

With the development of science and technology, crystals (e.g., silicon carbide) are widely used in different optoelectronic devices and electronic devices. While the demand for crystals is gradually increasing, how to improve the quality of crystal growth has become a focus of attention in the field.

During a crystal growth process, a crystal surface temperature of a crystal is a core factor of crystal growth quality. However, it is difficult to observe the crystal surface temperature during the crystal growth process. Consequently, the crystal surface temperature cannot be accurately controlled during the crystal growth process, and the crystal growth quality is not high.

Therefore, how to improve the quality of crystal growth is an urgent technical problem to be solved in the field.

### SUMMARY

One or more embodiments of the present disclosure provide a method for crystal growth. The method includes: determining a parameter set of a crystal growth apparatus in a target batch, wherein the parameter set includes at least one target parameter, and the target parameter is a parameter that affects crystal growth in the crystal growth apparatus; acquiring, in a target time period of the target batch, a first temperature detection value of a first temperature measuring point of the crystal growth apparatus; and determining, based on the target parameter and the first temperature detection value, a simulated crystal surface temperature corresponding to the first temperature detection value through a crystal surface temperature determination model.

In some embodiments, the method further includes: determining, based on the simulated crystal surface temperature, a temperature control parameter of the crystal growth apparatus in the target time period of the target batch.

In some embodiments, the method further includes: automatically sending a temperature adjustment instruction based on the temperature control parameter to adjust a crystal growth temperature of the crystal growth apparatus in the target time period.

In some embodiments, the target parameter includes a target first parameter and a target second parameter; the target first parameter includes a first parameter of a preset object in the crystal growth apparatus in the target batch, the first parameter reflecting a material physical property of the preset object related to crystal growth; and the target second parameter includes a second parameter of the crystal growth apparatus in the target batch, the second parameter including a parameter related to a relevant setting of the crystal growth apparatus.

In some embodiments, the material physical property includes at least one of a heat transfer coefficient, an electrical conductivity, a surface emissivity, a specific heat capacity at constant pressure, and a relative permeability.

In some embodiments, the preset object includes at least one of a crucible, a thermal insulation felt, a raw material melt, and a protective gas.

In some embodiments, the determining the parameter set of the crystal growth apparatus in the target batch includes: acquiring an initial first parameter, wherein the initial first parameter reflects the first parameter of the preset object in the crystal growth apparatus in an initial environment; and determining the target first parameter by processing the initial first parameter based on a reinforcement learning model, wherein a reward value of the reinforcement learning model is related to furnace interior information of the crystal growth apparatus.

In some embodiments, the determining the parameter set of the crystal growth apparatus in the target batch includes: acquiring a first correspondence relationship between batches of the crystal growth apparatus and the first parameter; and determining the target first parameter based on the target batch and the first correspondence relationship.

In some embodiments, the first correspondence relationship is determined through the following steps: for each of a plurality of preset batches of the crystal growth apparatus, determining a reference first parameter corresponding to the preset batch by processing an initial first parameter based on a reinforcement learning model, wherein the initial first parameter reflects the first parameter of the preset object in the crystal growth apparatus in an initial environment, the reference first parameter is the first parameter of the crystal growth apparatus in the preset batch, and a reward value of the reinforcement learning model is related to furnace interior information of the crystal growth apparatus; and determining the first correspondence relationship between the batches of the crystal growth apparatus and the first parameter based on the reference first parameters corresponding to the plurality of preset batches.

In some embodiments, the determining the parameter set of the crystal growth apparatus in the target batch includes: acquiring historical first parameters of the crystal growth apparatus in a plurality of historical batches and historical working condition parameters corresponding to the historical first parameters, wherein the historical first parameters include the first parameter reflecting the preset object in the crystal growth apparatus in the historical batches; and determining the target first parameter based on the historical first parameters and the historical working condition parameters of the plurality of historical batches.

In some embodiments, the historical working condition parameters include a second temperature detection value of a second temperature measuring point of the crystal growth apparatus in the plurality of historical batches; the determining the first parameter based on the historical first parameters and the historical working condition parameters of the plurality of historical batches includes: determining a second correspondence relationship based on the historical first parameters and the second temperature detection values of the plurality of historical batches, wherein the second correspondence relationship reflects a correspondence relationship between the temperature detection value of the second temperature measuring point of the crystal growth apparatus and the first parameter; acquiring a third temperature detection value of the second temperature measuring point of the crystal growth apparatus in the target batch; and determining the target first parameter based on the third temperature detection value and the second correspondence relationship.

In some embodiments, the historical working condition parameters include a historical growth duration of crystal growth of the crystal growth apparatus in the historical batches; the determining the target first parameter based on the historical first parameters and the historical working condition parameters of the plurality of historical batches includes: determining a third correspondence relationship based on the historical first parameters and the historical growth durations of the plurality of historical batches, the third correspondence relationship reflecting a correspondence relationship between a growth duration of a crystal and the first parameter; acquiring a target growth duration of crystal growth of the crystal growth apparatus in the target batch; and determining the target first parameter based on the target growth duration and the third correspondence relationship.

In some embodiments, the determining the target first parameter based on the historical first parameters and the historical working condition parameters of the plurality of historical batches includes: establishing a parameter prediction model based on the historical first parameters and the historical working condition parameters of the plurality of historical batches; determining a preset working condition parameter of the crystal growth apparatus in the target batch; and determining the target first parameter based on the preset working condition parameter and the parameter prediction model.

In some embodiments, the type of the first parameter is determined through the following steps: acquiring a plurality of sets of reference data, each set of the reference data including a plurality of candidate first parameters and validation information corresponding to the plurality of candidate first parameters, each of the candidate first parameters reflecting a material physical property of the preset object in the crystal growth apparatus; and determining the type of the first parameter by processing the plurality of sets of the reference data through an importance analysis model, the importance analysis model being a random forest model.

In some embodiments, the determining, based on the simulated crystal surface temperature, the temperature control parameter of the crystal growth apparatus in the target time period of the target batch includes: acquiring a plurality of reference crystal surface temperatures of each of a plurality of reference apparatuses in a reference batch and a plurality of reference control parameters corresponding to the plurality of reference crystal surface temperatures, wherein the reference apparatus is an apparatus of the same type as the crystal growth apparatus; and determining the temperature control parameter based on the reference crystal surface temperatures, the reference control parameters of the plurality of reference apparatuses in the reference batch, and the simulated crystal surface temperature.

In some embodiments, the determining the temperature control parameter based on the plurality of reference crystal surface temperatures, the plurality of reference control parameters, and the simulated crystal surface temperature includes: acquiring crystal detection data of crystals generated by the plurality of reference apparatuses in the reference batch; and determining the temperature control parameter based on the reference crystal surface temperatures, the reference control parameters of the plurality of reference apparatuses in the reference batch, the crystal detection data, and the simulated crystal surface temperature.

One or more embodiments of the present disclosure provide a system for crystal growth. The system includes: a parameter determination module, configured to determine a parameter set of a crystal growth apparatus in a target batch, wherein the parameter set includes at least one target parameter, and the target parameter is a parameter that affects crystal growth in the crystal growth apparatus; a temperature detection module, configured to acquire a first temperature detection value of a first temperature measuring point of the crystal growth apparatus in a target time period of the target batch; and a temperature determination module, configured to determine, based on the target parameter and the first temperature detection value, a simulated crystal surface temperature corresponding to the first temperature detection value through a crystal surface temperature determination model.

In some embodiments, the system further includes: a temperature control module, configured to determine, based on the simulated crystal surface temperature, a temperature control parameter of the crystal growth apparatus in the target time period of the target batch.

In some embodiments, the system further includes: a temperature adjustment module, configured to automatically send a temperature adjustment instruction based on the temperature control parameter so as to adjust a crystal growth temperature of the crystal growth apparatus in the target time period of the target batch.

In some embodiments, the target parameter includes a target first parameter and a target second parameter; the target first parameter includes a first parameter of a preset object in the crystal growth apparatus in the target batch, the first parameter reflecting a material physical property of the preset object related to crystal growth; and the target second parameter includes a second parameter of the crystal growth apparatus in the target batch, the second parameter including a parameter of a relevant setting of the crystal growth apparatus.

In some embodiments, the parameter determination module is further configured to: acquire an initial first parameter, wherein the initial first parameter reflects the first parameter of the preset object in the crystal growth apparatus in an initial environment; and determine the target first parameter by processing the initial first parameter based on a reinforcement learning model, wherein a reward value of the reinforcement learning model is related to furnace interior information of the crystal growth apparatus.

In some embodiments, the parameter determination module is further configured to: acquire a first correspondence relationship between batches of the crystal growth apparatus and the first parameter; and determine the target first parameter based on the target batch and the first correspondence relationship.

In some embodiments, the parameter determination module is further configured to: for each of a plurality of preset batches of the crystal growth apparatus, determine a reference first parameter corresponding to the preset batch by processing an initial first parameter based on a reinforcement learning model, wherein the initial first parameter reflects the first parameter of the preset object in the crystal growth apparatus in an initial environment, the reference first parameter is the first parameter of the crystal growth apparatus in the preset batch, and a reward value of the reinforcement learning model is related to furnace interior information of the crystal growth apparatus; and determine a first correspondence relationship between the batches of the crystal growth apparatus and the first parameter based on the reference first parameters corresponding to the plurality of preset batches.

In some embodiments, the parameter determination module is further configured to: acquire historical first parameters of the crystal growth apparatus in a plurality of historical batches and historical working condition parameters corresponding to the historical first parameters, wherein the historical first parameters include the first parameter reflecting the preset object in the crystal growth apparatus in the historical batches; and determine the target first parameter based on the historical first parameters and the historical working condition parameters of the plurality of historical batches.

In some embodiments, the historical working condition parameters include a second temperature detection value of a second temperature measuring point of the crystal growth apparatus in the plurality of historical batches; the parameter determination module is further configured to: determine a second correspondence relationship based on the historical first parameters and the second temperature detection values of the plurality of historical batches, wherein the second correspondence relationship reflects a correspondence relationship between the temperature detection value of the second temperature measuring point of the crystal growth apparatus and the first parameter; acquire a third temperature detection value of the second temperature measuring point of the crystal growth apparatus in the target batch; and determine the target first parameter based on the third temperature detection value and the second correspondence relationship.

In some embodiments, the historical working condition parameters include a historical growth duration of crystal growth of the crystal growth apparatus in the historical batches; the parameter determination module is further configured to: determine a third correspondence relationship based on the historical first parameters and the historical growth durations of the plurality of historical batches, the third correspondence relationship reflecting a correspondence relationship between a growth duration of a crystal and the first parameter; acquire a target growth duration of crystal growth of the crystal growth apparatus in the target batch; and determine the target first parameter based on the target growth duration and the third correspondence relationship.

In some embodiments, the parameter determination module is further configured to: establish a parameter prediction model based on the historical first parameters and the historical working condition parameters of the plurality of historical batches; determine a preset working condition parameter of the crystal growth apparatus in the target batch; and determine the target first parameter based on the preset working condition parameter and the parameter prediction model.

In some embodiments, the parameter determination module is further configured to: acquire a plurality of sets of reference data, each set of the reference data including a plurality of candidate first parameters and validation information corresponding to the plurality of candidate first parameters, each of the candidate first parameters reflecting a material physical property of the preset object in the crystal growth apparatus; and determine a type of the first parameter by processing the plurality of sets of the reference data through an importance analysis model, the importance analysis model being a random forest model.

In some embodiments, the temperature control module is further configured to: acquire a plurality of reference crystal surface temperatures of each of a plurality of reference apparatuses in a reference batch and a plurality of reference control parameters corresponding to the plurality of reference crystal surface temperatures, wherein the reference apparatus is an apparatus of the same type as the crystal growth apparatus; and determine the temperature control parameter based on the reference crystal surface temperatures, the reference control parameters of the plurality of reference apparatuses in the reference batch, and the simulated crystal surface temperature.

In some embodiments, the temperature control module is further configured to: acquire crystal detection data of crystals generated by the plurality of reference apparatuses in the reference batch; and determine the temperature control parameter based on the reference crystal surface temperatures, the reference control parameters of the plurality of reference apparatuses in the reference batch, the crystal detection data, and the simulated crystal surface temperature.

One or more embodiments of the present disclosure provide a crystal growth apparatus, comprising a crystal growth device and a processor, wherein the processor is configured to execute the method for crystal growth according to any one of the above embodiments.

One or more embodiments of the present disclosure provide a non-transitory computer-readable storage medium, wherein the storage medium stores computer instructions, and when a computer reads the computer instructions in the storage medium, the computer executes the method for crystal growth according to any one of the above embodiments.

### BRIEF DESCRIPTION OF THE DRAWINGS

The present disclosure is further described in terms of exemplary embodiments. These exemplary embodiments are described in detail with reference to the drawings. These embodiments are non-limiting, and in these embodiments, like numerals represent like structures, wherein:
FIG. 1 is a schematic diagram illustrating an application scenario of a system for crystal growth according to some embodiments of the present disclosure;
FIG. 2 is a flowchart illustrating an exemplary process for a method for crystal growth according to some embodiments of the present disclosure;
FIG. 3 is a flowchart illustrating an exemplary process for determining a first parameter according to some embodiments of the present disclosure;
FIG. 4 is a schematic diagram illustrating a reinforcement learning model according to some embodiments of the present disclosure;
FIG. 5 is a flowchart illustrating an exemplary process for determining a target first parameter according to some embodiments of the present disclosure;
FIG. 6 is a flowchart illustrating another exemplary process for determining a target first parameter according to some embodiments of the present disclosure;
FIG. 7 is a schematic diagram illustrating an application scenario of a system for crystal growth according to some embodiments of the present disclosure.

### DETAILED DESCRIPTION

In order to more clearly illustrate the technical solutions of the embodiments of the present disclosure, a brief introduction will be provided for the accompanying drawings to be used in the description of the embodiments. It is apparent that the accompanying drawings in the following description are merely some examples or embodiments of the present disclosure. For those skilled in the art, without inventive efforts, the present disclosure may also be applied to other similar scenarios based on the accompanying drawings. Unless it is apparent from the context or stated otherwise, the same reference numerals in the drawings represent the same structures or operations.

It should be understood that the terms 'system', 'apparatus', 'unit', and/or 'module' used herein are a manner for distinguishing different components, elements, parts, portions, or assemblies at different levels. However, if other words can achieve the same purpose, then the words may be replaced by other expressions.

As shown in the present disclosure and the claims, unless the context clearly indicates otherwise, the terms 'a', 'an', and/or 'the' are not limited to the singular form, but may also include the plural form. Generally, the terms 'comprising' and 'including' merely indicate the inclusion of explicitly identified steps and elements, and these steps and elements do not constitute an exclusive list. A manner or an apparatus may also include other steps or elements.

A flowchart is used in the present disclosure to illustrate operations performed by a system according to embodiments of the present disclosure. It should be understood that the preceding or subsequent operations are not necessarily performed in an exact order. Instead, the steps may be processed in reverse order or simultaneously. Meanwhile, other operations may also be added to these processes, or one or more operations may be removed from these processes.

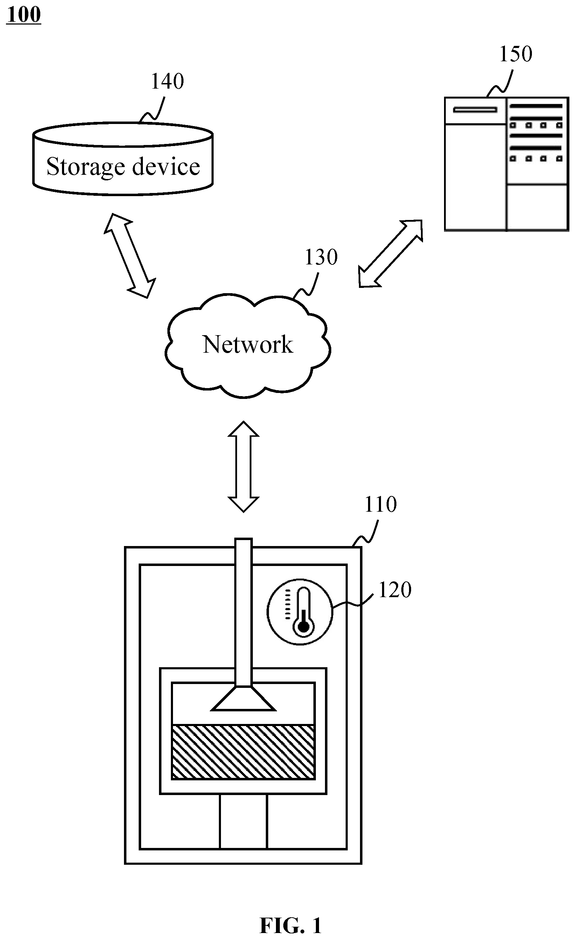

FIG. 1 is a schematic diagram illustrating an application scenario 100 of a system for crystal growth according to some embodiments of the present disclosure.

As shown in FIG. 1, the application scenario 100 of the system for crystal growth may include a crystal growth apparatus 110, a temperature detection apparatus 120, a network 130, a storage device 140, and a processor 150.

The crystal growth apparatus 110 is an apparatus configured to grow crystals. The aforementioned crystals may include, but are not limited to, silicon carbide, germanium single crystal, or the like. The crystal growth apparatus 110 may include, but is not limited to, physical vapor transport crystal growth apparatuses, liquid phase epitaxy crystal growth apparatuses, Czochralski crystal growth apparatuses, or the like. The crystal growth apparatus 110 may include a furnace body, a crucible, a thermal insulation layer, a seed crystal holder, or the like. It can be understood that any of the aforementioned manners for crystal growth may determine a crystal surface temperature during a crystal growth process through the method for crystal growth shown in any embodiment of the present disclosure, to complete crystal growth.

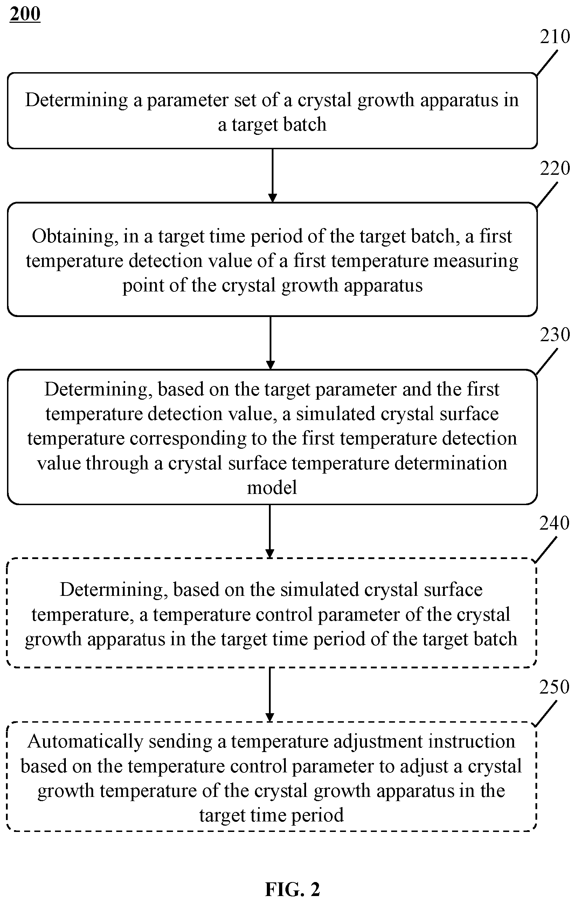

The temperature detection apparatus 120 is an apparatus configured to detect a temperature. The temperature detection apparatus 120 may include, but is not limited to, an infrared thermal imager, an optical fiber temperature sensor, or the like. The temperature detection apparatus 120 may be arranged in the crystal growth apparatus 110 to acquire a first temperature detection value of a first temperature measuring point of the crystal growth apparatus 110 in a target time period of a target batch. More descriptions regarding the target batch, the target time period, the first temperature measuring point, and the first temperature detection value may be found elsewhere in the present disclosure (e.g., FIG. 2 and related descriptions thereof).

The network 130 may connect various components of the application scenario 100 of the system for crystal growth and/or connect to external resource portions. The network 130 allows communication among the various components and with other portions, facilitating the exchange of data and/or information. For example, the processor 150 may acquire, through the network 130, the first temperature detection value detected by the temperature detection apparatus 120. For example, the processor 150 may also control the crystal growth apparatus 110 through the network 130. The network 130 may be any one or a plurality of wired networks or wireless networks. For example, the network 130 may include a cable network, an optical fiber network, a telecommunications network, the Internet, a local area network, a wide area network, a wireless local area network, a metropolitan area network, a public switched telephone network, a Bluetooth network, a ZigBee network, near field communication, an in-device bus, an in-device line, a cable connection, or the like, or any combination thereof. The network connections among the various portions may adopt one of the aforementioned manners, or may adopt a plurality of manners. A network may be various topologies such as point-to-point, shared, centralized, or the like, or a combination of a plurality of topologies.

The storage device 140 may be configured to store data and/or instructions. For example, the storage device 140 may be configured to store historical data of the crystal growth apparatus 110, apparatus information, or the like. The storage device 140 may include one or a plurality of storage components, wherein each storage component may be a standalone apparatus or a portion of other apparatuses. The storage device 140 may include a random access memory, a read-only memory, mass storage, a removable memory, a volatile read-write memory, or the like, or any combination thereof. Merely by way of example, the mass storage may include a magnetic disk, an optical disc, a solid-state disk, or the like. In some embodiments, the storage device 140 may be implemented on a cloud platform.

The processor 150 may process data and/or information obtained from external resources or various components of the application scenario 100 of the system for crystal growth. For example, the processor 150 may determine a parameter set of the crystal growth apparatus 110 in a target batch. The processor may execute program instructions based on the data, the information, and/or processing results to perform one or a plurality of functions described in the present disclosure. For example, the processor 150 may determine, based on the target parameter and the first temperature detection value, a simulated crystal surface temperature corresponding to the first temperature detection value through the crystal surface temperature determination model. For example, the processor 150 may also determine, based on the simulated crystal surface temperature, a temperature control parameter of the crystal growth apparatus 110 in the target time period of the target batch. More descriptions regarding the aforementioned examples may be found in the following related descriptions. The processor 150 may include one or a plurality of sub-processing apparatuses (e.g., a single-core processing apparatus or a multi-core multi-chip processing apparatus). Merely by way of example, the processor 150 may include a central processing unit, an application-specific integrated circuit, a dedicated instruction processor, a graphics processing unit, a physical processor, a digital signal processor, a field programmable gate array, an editable logic circuit, a controller, a microcontroller unit, a reduced instruction set computer, a microprocessor, or the like, or any combination of the above.

It should be noted that the application scenario 100 of the system for crystal growth is provided merely for illustrative purposes and is not intended to limit the scope of the present disclosure. For those skilled in the art, a plurality of modifications or variations may be made according to the descriptions of the present disclosure. For example, the application scenario 100 of the system for crystal growth may also include a database, an information source, or the like. For example, the application scenario 100 of the system for crystal growth may be implemented on other apparatuses to realize similar or different functions. However, variations and modifications will not depart from the scope of the present disclosure.

FIG. 2 is a flowchart illustrating an exemplary method for crystal growth according to some embodiments of the present disclosure. In some embodiments, a process 200 may be executed by a system for crystal growth 700. As shown in FIG. 2, the process 200 includes the following steps.

In 210, a parameter set of a crystal growth apparatus in a target batch is determined. In some embodiments, the step 210 may be executed by a parameter determination module 710.

The target batch refers to a batch in which the crystal growth apparatus (e.g., the crystal growth apparatus 110 shown in FIG. 1) is currently performing crystal growth. For example, the target batch may be a '20th batch', indicating that the crystal growth apparatus is currently in the process of the '20th batch' of crystal growth.

The parameter set is a collection of target parameters of the crystal growth apparatus in the target batch, and the parameter set may include at least one target parameter.

The target parameter is a parameter that affects crystal growth in the crystal growth apparatus. Specifically, the target parameter may affect a speed of crystal growth, a quality of the grown crystal, or the like. In some embodiments, the target parameter may include a target first parameter and a target second parameter.

The target first parameter may include a first parameter of a preset object in the crystal growth apparatus in the target batch. The preset object may include at least one of a crucible, a thermal insulation felt (e.g., a soft felt and/or a hard felt), a raw material melt, and a protective gas (e.g., argon). The first parameter may reflect a material physical property of the preset object related to crystal growth.

In some embodiments, the parameter determination module 710 may determine a type of the first parameter. It may be understood that the material physical property of the preset object includes a plurality of different types of parameters. Merely by way of example, the material physical property of the preset object may include parameters regarding density, optical property, mechanical property, thermal property, electrical property, and magnetic property of the preset object, or the like. However, when a portion of the material physical properties of the preset object (e.g., the mechanical property) changes, it may have a relatively large impact on a crystal surface temperature; when a portion of the material physical properties of the preset object (e.g., the thermal property) changes, it may have a relatively small impact on the crystal surface temperature. In some embodiments, the parameter determination module 710 may determine, as the first parameter, a parameter of the material physical property of the preset object that has a relatively large impact on the crystal surface temperature when changed, and detects the target first parameter in the target batch of the crystal growth apparatus through the plurality of aforementioned embodiments, thereby reducing the computation amount and avoiding a waste of computing resources. In some embodiments, the first parameter may include at least one of parameters regarding the thermal property, the electrical property, and the magnetic property of the preset object, or the like. Merely by way of example, the first parameter may include at least one of a heat transfer coefficient, an electrical conductivity, a surface emissivity, a thermal conductivity, a specific heat capacity at constant pressure, and a relative permeability.

In some embodiments, the parameter determination module 710 may acquire a plurality of sets of reference data. The reference data may be data configured to determine the type of the first parameter. Each set of the reference data may include a plurality of candidate first parameters and validation information corresponding to the plurality of candidate first parameters. A candidate first parameter may be a parameter whose suitability for being identified as the first parameter is to be evaluated. A candidate first parameter may encompass all material physical properties of the preset object or a portion of user-specified material physical properties. Each candidate first parameter may reflect a material physical property of the preset object in the crystal growth apparatus. The validation information refers to information for validating the importance of the first parameter. For example, the validation information may include, but is not limited to, a furnace internal temperature, a furnace internal pressure, crystal growth quality, or the like. The reference data may be obtained through historical data of the crystal growth apparatus. For example, a plurality of candidate first parameters and validation information in a certain set of the reference data may be obtained by measuring the preset object of the crystal growth apparatus in a historical batch.

In some embodiments, the parameter determination module 710 may process a plurality of sets of the reference data through an importance analysis model to determine the type of the first parameter, wherein the importance analysis model is a random forest model. For example, the parameter determination module 710 may process a plurality of sets of the reference data through the importance analysis model to determine four types of the first parameter from 20 types of the material physical property of the preset object, which are respectively a surface emissivity, a thermal conductivity, a specific heat capacity at constant pressure, and a relative permeability.

The importance analysis model may analyze a plurality of input candidate first parameters through input validation information, determine importance corresponding to each candidate first parameter, thereby determining the type of the first parameter. The importance corresponding to each of the aforementioned candidate first parameters may be represented in a plurality of manners. For example, the importance may be a value, a ratio, or the like. Merely by way of example, the parameter determination module 710 may determine, as the type of the first parameter, a type of the candidate first parameter whose importance exceeds a preset importance threshold. Some embodiments of the present disclosure filter a plurality of candidate first parameters through the random forest model to determine the type of the first parameter, thereby avoiding interference from a material physical property of the preset object that has little impact on crystal growth, and reducing a computation amount of the system for crystal growth 700.

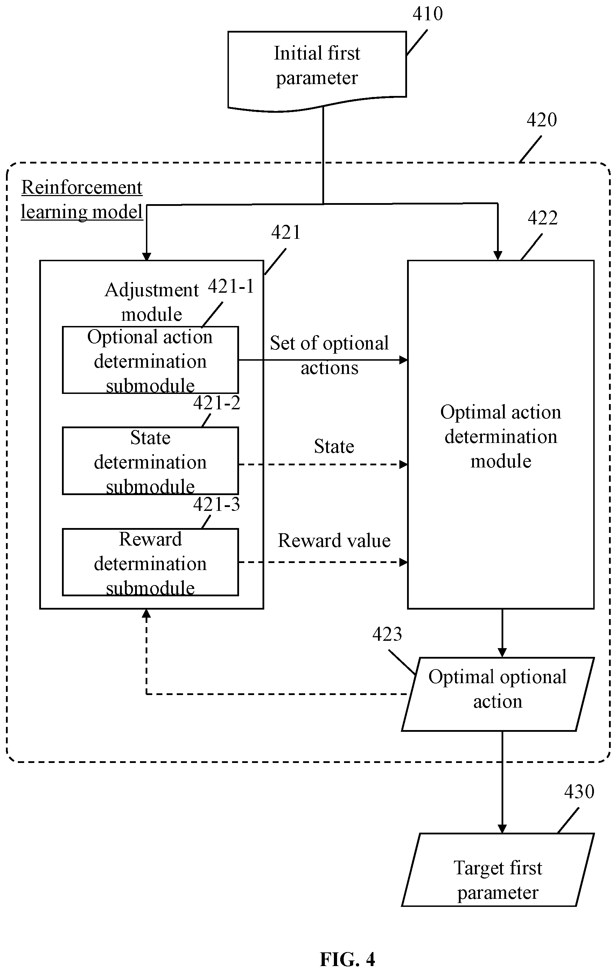

In some embodiments, the parameter determination module 710 may determine the target first parameter of the crystal growth apparatus in the target batch based on an initial first parameter corresponding to the preset object. For example, the parameter determination module 710 may determine the target first parameter of the crystal growth apparatus in the target batch based on the equipment information of the crystal growth apparatus. The aforementioned equipment information may include relevant information of the crystal growth apparatus. The equipment information may include, but is not limited to, a type of the crystal growth apparatus, an overall size, a size of the preset object, an initial first parameter, or the like. The equipment information may be provided by a manufacturer of the crystal growth apparatus. More descriptions regarding the initial first parameter may be found elsewhere in the present disclosure (e.g., FIG. 4 and related descriptions thereof).

In some embodiments, the parameter determination module 710 may determine a specific value of the target first parameter. It is worth noting that, when in a normal temperature state, the first parameter is relatively stable. For example, the electrical conductivity may be a fixed value. However, when a crystal grows inside the crystal growth apparatus, the crystal growth apparatus heats the crucible by induction via an induction coil, therefore, a temperature of a crystal growth environment is relatively high (e.g., approximately 900 to 7200°C), and is located in an electric field and a magnetic field. In this case, the first parameter may change depending on a furnace internal environment of the crystal growth apparatus. Furthermore, when the crystal growth apparatus is in use, material properties of the preset object may also change with use, thereby causing the first parameter to change. Based on this, to more accurately determine the crystal surface temperature during crystal growth, the parameter determination module 710 may determine the target first parameter of the crystal growth apparatus in the target batch by a plurality of manners, namely, a specific value of the first parameter in the target batch.

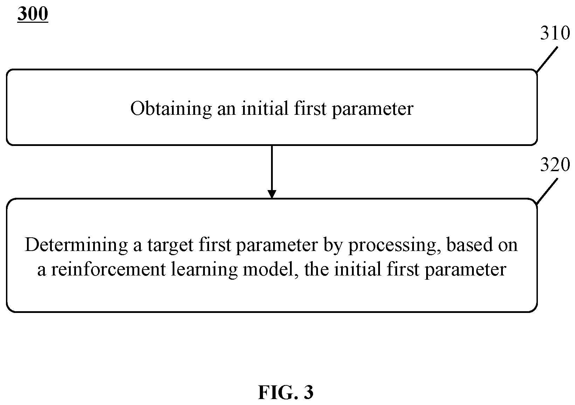

In some embodiments, the parameter determination module 710 may acquire an initial first parameter, wherein the initial first parameter reflects the first parameter of the preset object in the crystal growth apparatus in an initial environment; and process the initial first parameter based on a reinforcement learning model to determine the target first parameter, wherein a reward value of the reinforcement learning model is related to furnace interior information of the crystal growth apparatus. More descriptions regarding the aforementioned embodiment may be found elsewhere in the present disclosure (e.g., FIG. 3 and related descriptions thereof).

In some embodiments, the parameter determination module 710 may further acquire a first correspondence relationship between batches of the crystal growth apparatus and the first parameter; and determine the target first parameter based on the target batch and the first correspondence relationship. More descriptions regarding the aforementioned embodiment may be found elsewhere in the present disclosure (e.g., FIG. 4 and related descriptions thereof).

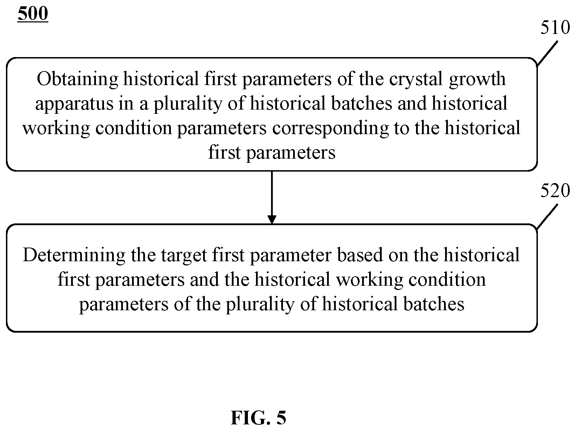

In some embodiments, the parameter determination module 710 may further acquire the historical first parameters of the crystal growth apparatus in a plurality of historical batches and the historical working condition parameters corresponding to the historical first parameters, wherein the historical first parameters comprise the first parameter reflecting the preset object in the crystal growth apparatus in the historical batches; and determine the target first parameter based on the historical first parameters of the plurality of historical batches and the historical working condition parameters. More descriptions regarding the aforementioned embodiment may be found elsewhere in the present disclosure (e.g., FIG. 5 and related descriptions thereof).

The target second parameter may include a second parameter of the crystal growth apparatus in the target batch. The second parameter may include a parameter related to a relevant setting of the crystal growth apparatus in the target batch.

In some embodiments, the parameter determination module 710 may determine a type of the second parameter by presetting, and further determine a numerical value of the target second parameter in the target batch. The second parameter may include batch apparatus parameters and batch growth parameters. The aforementioned batch apparatus parameters may be parameters related to the crystal growth apparatus. Illustratively, the batch apparatus parameters may include, but are not limited to, a number of top insulation layers, a distance between a bottom of a top insulation and a top of the crucible, a number of soft felts, a minimum inner diameter, a maximum outer diameter, a lid thickness, a material distance, a gasket inner diameter, a material height, a bottom insulation soft felt, an inner insulation cylinder hard felt, an inner insulation cylinder soft felt, an outer insulation cylinder hard felt, an outer insulation cylinder soft felt, an outermost soft felt, a coil height, or the like. The batch growth parameters may be parameters related to crystal growth settings. For example, the batch growth parameters may include a growth pressure, a growth power, a high temperature, a high-temperature line, a crystal growth time, a center thickness, an edge thickness, or the like. Different batches of the crystal growth apparatus may result in different corresponding second parameters due to differences in a type of generated crystal, crystal demand, or the like.

In some embodiments, the target second parameter may be obtained through a preset of the target batch. For example, by a user (e.g., a manager of the crystal growth apparatus) inputting the batch apparatus parameters and the batch growth parameters of the target batch, the target second parameter is determined. For further example, based on a preset type of the crystal growth apparatus, the batch apparatus parameters of the crystal growth apparatus in the target batch may be determined. For yet another example, based on a preset type of crystal, crystal demand, or the like, the batch growth parameters of the crystal growth apparatus in the target batch may be determined.

In 220, a first temperature detection value of a first temperature measuring point of the crystal growth apparatus in the target time period of the target batch is acquired. In some embodiments, Step 220 may be performed by a temperature detection module 720.

The target time period refers to a time period for measuring a temperature of the first temperature measuring point. The target time period may be preset and determined by a user (e.g., an operator of the crystal growth apparatus). The target batch may include a plurality of time periods, and the target time period may be a currently present time period.

The temperature detection module 720 may perform at least one temperature detection within the target time period to acquire a first temperature detection value of a first temperature measuring point of the crystal growth apparatus. The aforementioned temperature detection module 720 may be implemented by a temperature detection apparatus (e.g., the temperature detection apparatus 120 shown in FIG. 1).

The first temperature measuring point is a temperature measuring point within the crystal growth apparatus (e.g., within a furnace of the crystal growth apparatus), and the first temperature detection value is a temperature of the first temperature measuring point obtained by detection.

The crystal growth apparatus may include one or more first temperature measuring points. The first temperature measuring point may be preset and determined by a user. A user may set a temperature detection device at one or more locations, and the temperature detection module 720 may acquire a first temperature detection value of the first temperature measuring point in the target time period of the target batch through the aforementioned temperature detection device.

In 230, a simulated crystal surface temperature corresponding to the first temperature detection value is determined based on the target parameter and the first temperature detection value through a crystal surface temperature determination model. In some embodiments, step 230 may be performed by a temperature determination module 730.

The simulated crystal surface temperature refers to a crystal surface temperature determined through simulation and corresponding to the first temperature detection value.

The crystal surface temperature determination model may be the numerical simulation model. The processor 150 may establish a plurality of mathematical equations based on historical target parameters, historical first temperature detection values, and historical crystal surface temperatures of a plurality of historical batches. The processor 150 may further discretize the plurality of mathematical equations, thereby converting them into a discrete form for facilitating processing. By employing a numerical determination manner (e.g., a finite difference method, a finite element method, or the like), the aforementioned discretized mathematical equations may be solved to obtain the crystal surface temperature determination model. The temperature determination module 730 may input the target parameter and the first temperature detection value to the crystal surface temperature determination model. The crystal surface temperature determination model performs simulation based on input data to determine the simulated crystal surface temperature.

Some embodiments of the present disclosure may determine the simulated crystal surface temperature through the crystal surface temperature determination model, thereby addressing a situation where the crystal surface temperature is difficult to observe.

In some embodiments, the crystal surface temperature determination model may also be the machine learning model. For example, the crystal surface temperature determination model may include, but is not limited to, one or a combination of a logistic regression model, a decision tree model, a stochastic gradient descent model, or the like. The input of the crystal surface temperature determination model may include the target parameter and the first temperature detection value, and the output may include the simulated crystal surface temperature corresponding to the first temperature detection value. The aforementioned crystal surface temperature determination model may be obtained by modeling the crystal growth apparatus through numerical simulation software (e.g., Virtual reactor, COMSOL, or the like) or a designed heat transfer determination program to obtain an initial crystal surface temperature determination model, and then training the initial crystal surface temperature determination model. A first training sample may include sample target parameters and sample first temperature detection values, and a first training label may include sample crystal surface temperatures. The aforementioned first training sample and the first training label may be obtained by performing a heating experiment on the crystal growth apparatus.

In some embodiments, the temperature determination module 730 may also determine the corresponding crystal surface temperature determination model based on a crystal growth apparatus type. The crystal surface temperature determination model corresponding to each crystal growth apparatus type may be obtained by separately performing training based on the first training sample and the first training label corresponding to each crystal growth apparatus type.

In some embodiments, the input of the crystal surface temperature determination model may also include position information of the first temperature measuring point. Correspondingly, during training, the first training sample may also include sample position information of a sample first temperature measuring point. By also using the position information of the first temperature measuring point as an input of the crystal surface temperature determination model, errors caused by differences in positions of the first temperature measuring point may be avoided, thereby improving the accuracy rate of the output of the crystal surface temperature determination model.

In some embodiments, the crystal surface temperature determination model may also include a numerical simulation model and a machine learning model. For example, the temperature determination module 730 may process the target parameter and the first temperature detection value based on the numerical simulation model and the machine learning model, perform a weighted sum on results outputted by both, and determine the result of the weighted sum as the simulated crystal surface temperature. The aforementioned numerical simulation model and the machine learning model may be obtained through presetting. The numerical simulation model is typically affected by uncertainties from different sources, such as model parameter uncertainty, noise of the input data, or the like. The machine learning model may be applied to estimate and model uncertainty, to provide more accurate prediction results and effective uncertainty quantification. By integrating the output results of both, the more accurate simulated crystal surface temperature may be obtained.

Through some embodiments of the present disclosure, the parameter set of the crystal growth apparatus in the target batch may be more accurately determined, thereby more accurately determining the crystal surface temperature during a crystal growth manner, and improving the quality of crystal growth. In addition, by determining the crystal surface temperature through the crystal surface temperature determination model, determination efficiency may be improved, and manual determination costs may be reduced.

In some embodiments, after determining the simulated crystal surface temperature, the process 200 may also determine the temperature control parameter for adjusting the temperature of the crystal growth apparatus in the target time period. Optionally, the process 200 may also include the following steps.

In 240, a temperature control parameter of the crystal growth apparatus in the target time period of the target batch is determined based on the simulated crystal surface temperature. In some embodiments, step 240 may be performed by a temperature control module 740.

The temperature control parameter refers to a parameter by which the crystal growth apparatus adjusts the furnace internal temperature. The temperature control parameter may include power of the furnace chamber of the crystal growth apparatus. For example, the temperature control parameter may be '+5KW', indicating that it is necessary to increase a current power of the furnace chamber by 5KW during the target time period. The temperature control parameter may also include an adjustment value for the furnace internal temperature of the crystal growth apparatus. For example, the temperature control parameter may be '+100°C', indicating that it is necessary to increase a current furnace internal temperature of a furnace chamber by 100°C during the target time period.

In some embodiments, the temperature control module 740 may feed back the simulated crystal surface temperature to an operator associated with the target batch. The aforementioned operator may determine the temperature control parameter of the crystal growth apparatus in the target time period of the target batch based on the simulated crystal surface temperature.

In some embodiments, the temperature control module 740 may determine the temperature control parameter of the crystal growth apparatus in the target time period of the target batch based on crystal growth information of the target batch and the simulated crystal surface temperature, through a temperature control relationship. The crystal growth information may refer to related information of crystal growth of the target batch. For example, the crystal growth information may include, but is not limited to, a crystal type, a current crystal growth condition (e.g., size), a current crystal growth duration, a target growth duration, or the like. The aforementioned target growth duration refers to an estimated duration required for crystal growth in the target batch. The crystal growth information may be directly obtained through user input, or may be acquired in real time during the crystal growth manner. For example, the crystal type, the target growth duration, or the like may be directly determined through user input. For further example, the current crystal growth condition (e.g., crystal size) and the current crystal growth duration may be acquired in real time during the crystal growth manner.

The temperature control module 740 may determine the crystal surface temperature required for a crystal during the target time period based on the crystal growth information. The temperature control module 740 may further combine the simulated crystal surface temperature and a preset control rule relationship to determine the temperature control parameter of the crystal growth apparatus during the target time period. More descriptions regarding the temperature control relationship may be found in the following related descriptions.

The temperature control module 740 may acquire a plurality of reference crystal surface temperatures of each of a plurality of reference apparatuses in a reference batch and a plurality of reference control parameters corresponding to the plurality of reference crystal surface temperatures. The reference apparatus refers to an apparatus of the same type as the crystal growth apparatus. The reference batch refers to a crystal growth batch performed by the reference apparatus. The reference crystal surface temperature may refer to the crystal surface temperature of the reference apparatus in the reference batch. The aforementioned reference crystal surface temperature may be a temperature sequence, indicating different crystal surface temperatures of the reference apparatus in the reference batch during a plurality of time periods. The reference control parameter may refer to the temperature control parameter of the reference apparatus in the reference batch. The aforementioned reference control parameter may be a temperature control parameter sequence, indicating different temperature control parameters of the reference apparatus in the reference batch during a plurality of time periods.

In some embodiments, the temperature control module 740 may determine the temperature control parameter based on the reference crystal surface temperatures of the plurality of reference apparatuses in the reference batch, the reference control parameters of the plurality of reference apparatuses in the reference batch, and the simulated crystal surface temperature.

For example, the temperature control module 740 may determine the at least one reference batch based on the simulated crystal surface temperature and the reference crystal surface temperature, and further determine the temperature control parameter of the crystal growth apparatus in the target time period of the target batch based on the reference control parameters corresponding to the aforementioned at least one reference batch. When a quantity of the reference batch is one, the temperature control module 740 may directly determine the reference control parameter corresponding to the reference batch as the temperature control parameter of the crystal growth apparatus in the target time period of the target batch. It may be understood that, in the different reference batches, the reference control parameters corresponding to the same reference crystal surface temperature may be different. Therefore, when there are the plurality of reference batches, the temperature control module 740 may comprehensively evaluate the reference control parameters of the plurality of reference batches to determine the temperature control parameter of the crystal growth apparatus in the target time period of the target batch. For example, an average value or a median value of the reference control parameters corresponding to the plurality of reference batches may be determined, and the average value or the median value may be determined as the temperature control parameter of the crystal growth apparatus in the target time period of the target batch.

For example, the temperature control module 740 may determine the temperature control relationship between the temperature control parameter and the crystal surface temperature within the crystal growth apparatus, based on the plurality of reference crystal surface temperatures and the plurality of reference control parameters of the plurality of reference apparatuses in the reference batch. The temperature control relationship can characterize an influence of an adjustment of the temperature control parameter on the crystal surface temperature.

In some embodiments, the temperature control relationship may be characterized by a temperature control model. An input of the temperature control model may include the simulated crystal surface temperature from a start of crystal growth to the target time period, and an output is the temperature control parameter from the target time period to a completion of crystal growth.

The temperature control model may be obtained by training with the plurality of reference crystal surface temperatures and the plurality of reference control parameters of the plurality of reference apparatuses in the reference batch. The temperature control module 740 may mask or remove the crystal surface temperatures of a portion of time periods from the reference crystal surface temperatures, thereby obtaining a second training sample. The second training label may be the reference control parameters corresponding to the time periods of the aforementioned masking or removal. The temperature control module 740 may train an initial temperature control model based on the second training sample and the second training label, thereby obtaining the temperature control model.

The temperature control module 740 may determine the crystal surface temperature required by the crystal growth apparatus in the target time period of the target batch, based on the crystal growth information of the target batch. Based on the crystal surface temperature required by the crystal growth apparatus in the target time period of the target batch and the simulated crystal surface temperature, the temperature control module 740 may determine the temperature control parameter of the crystal growth apparatus in the target time period of the target batch through the temperature control relationship, thereby causing the grown crystal to meet requirements.

The temperature control module 740 may further acquire crystal detection data of the crystals generated by the plurality of reference apparatuses in the reference batch. The crystal detection data refers to related detection data of a crystal. For example, the crystal detection data may include, but is not limited to, crystal size, crystal quantity, or presence or absence of a crystal, or the like.

In some embodiments, the temperature control module 740 may determine the temperature control parameter based on the plurality of reference crystal surface temperatures of the plurality of reference apparatuses in the reference batch, the plurality of reference control parameters, the crystal detection data, and the simulated crystal surface temperature. The temperature control module 740 may filter the plurality of reference crystal surface temperatures and the plurality of reference control parameters of the plurality of reference apparatuses in the reference batch, based on the crystal growth information of the target batch and the crystal detection data of the plurality of reference apparatuses in the reference batch, thereby obtaining the filtered reference crystal surface temperatures and the filtered reference control parameters. Further, the temperature control module 740 may determine the temperature control parameter of the crystal growth apparatus in the target time period of the target batch, based on the filtered reference crystal surface temperatures, the filtered reference control parameters, and the simulated crystal surface temperature. For example, the temperature control module 740 may only retain the reference crystal surface temperatures and the reference control parameters corresponding to the reference batches where the crystal size in the crystal detection data is equal to or greater than a preset size threshold. By filtering the reference batches of the reference apparatuses using the crystal detection data, data that does not meet requirements may be filtered out, thereby allowing the temperature control parameter of the target batch in the target time period to better meet the requirements of the crystal growth information.

It is worth noting that, if the simulated crystal surface temperature is merely fed back to an operator as a reference, the operator further needs to set the temperature of a crystal growth furnace based on experience. This makes the monitoring of the crystal surface temperature still not comprehensive enough, cannot ensure a constant temperature of the crystal surface during a crystal growth process, and thereby may reduce the crystal growth quality. Some embodiments of the present disclosure determine the temperature control parameter through the temperature control module 740, thereby allowing the determined temperature control parameter to be more suitable for crystal growth, realizing automated control, reducing labor costs, and decreasing an operation error rate.

In some embodiments, the system for crystal growth may further adjust the crystal growth temperature of the crystal growth apparatus in the target time period, based on the temperature control parameter. Optionally, the process 200 may further include the following steps.

In 250, a temperature adjustment instruction is automatically sent based on the temperature control parameter, to adjust the crystal growth temperature of the crystal growth apparatus in the target time period of the target batch. In some embodiments, Step 250 may be executed by the temperature adjustment module 750.

The temperature adjustment instruction refers to a control instruction for each component in the crystal growth apparatus to adjust the temperature. The temperature adjustment module 750 may generate the corresponding temperature adjustment instruction based on the temperature control parameter, and send the temperature adjustment instruction to the corresponding components of the crystal growth apparatus, to adjust the crystal growth temperature of the crystal growth apparatus in the target time period of the target batch, thereby causing the crystal growth temperature to meet the requirements for crystal growth and improving crystal growth quality.

Merely by way of example, when the temperature control parameter includes adding 5 KW to power of a furnace chamber in the crystal growth apparatus, the temperature adjustment module 750 may convert it into the corresponding temperature adjustment instruction. The aforementioned temperature adjustment instruction may be sent to the furnace chamber. In response to the temperature adjustment instruction, the furnace chamber may increase the current power by 5 KW.

Some embodiments of the present disclosure may automatically control the crystal growth apparatus to perform temperature adjustment through the temperature control parameter, thereby realizing intelligent control of crystal growth and reducing costs brought by manual operation.

It is worth noting that, in the target batch of the crystal growth apparatus, the system for crystal growth 700 may continuously execute the process 200 to determine the crystal surface temperature of each time period, thereby realizing intelligent control of the crystal growth apparatus based on the aforementioned crystal surface temperatures, and improving the crystal growth quality.

It should be noted that the above descriptions regarding the process 200 are merely for example and illustration, and do not limit the scope of application of the present disclosure. For those skilled in the art, various modifications and changes may be made to the process 200 under the guidance of the present disclosure. However, these modifications and changes are still within the scope of the present disclosure. For example, the system for crystal growth 700 may execute Step 220 first, and then execute Step 210, which may also realize the method for crystal growth described in the aforementioned embodiments of the present disclosure.

FIG. 3 is a flowchart illustrating an exemplary process for determining the first parameter according to some embodiments of the present disclosure. In some embodiments, the process 300 may be executed by the parameter determination module 710. As shown in FIG. 3, the process 300 may include the following steps.

In 310, an initial first parameter is acquired.

The initial first parameter may reflect the first parameter of the preset object in the crystal growth apparatus in an initial environment. The initial environment may refer to the environment in which a manufacturer of the crystal growth apparatus measures the first parameter of the preset object, wherein the crystal growth apparatus has not undergone crystal growth at that time. One or more of temperature, a magnetic field, an electric field, or the like in the initial environment may be determined by a preset. The initial first parameter may be determined by apparatus information of the crystal growth apparatus. For example, a design manufacturer of the crystal growth apparatus may test the preset object in the initial environment (e.g., a temperature of 20 to 30°C, a magnetic field of 1 to 2 milligauss) when manufacturing the crystal growth apparatus, thereby determining the first parameter of the preset object under initial conditions.

It may be understood that, due to the environment in which the preset object is located changing relative to the initial environment during crystal growth (e.g., the temperature in the initial environment is 20 to 30°C, and the temperature during crystal growth is 7400 to 7500°C), in addition, with the use of the crystal growth apparatus, an internal structure of the preset object may also change, thereby causing the first parameter of the preset object in the crystal growth apparatus to constantly change.

In 320, the initial first parameter is processed based on the reinforcement learning model to determine the target first parameter.

For each initial first parameter, the parameter determination module 710 may input the initial first parameter into the reinforcement learning model, and the output of the reinforcement learning model is the corresponding target first parameter. The reward value of the aforementioned reinforcement learning model may be related to furnace interior information of the crystal growth apparatus. The aforementioned furnace interior information may be information related to the crystal growth apparatus during a crystal growth process, including but not limited to furnace internal temperature, furnace internal pressure, an exhaust rate, or the like. The aforementioned furnace interior information may be determined by a plurality of manners. The aforementioned furnace interior information may be determined based on detection. For example, the parameter determination module 710 may perform detection through a related detection apparatus to acquire the furnace interior information. The aforementioned furnace interior information may also be determined based on determination. For example, the parameter determination module 710 may also determine the furnace internal temperature based on the first temperature detection value, through a preset correspondence relationship between the furnace internal temperature and the first temperature detection value. In another example, the parameter determination module 710 may also determine the furnace internal temperature based on the target batch and the power of the crystal growth apparatus, through calculation.

The reinforcement learning model may be used to correct the initial first parameter to obtain the corrected target first parameter. The reinforcement learning model 420 includes an adjustment module 421 and an optimal action determination module 422.

As shown in FIG. 4, the parameter determination module 710 may input the initial first parameter 410 into the reinforcement learning model 420, and the output of the reinforcement learning model 420 is the target first parameter 430. Within the reinforcement learning model 420, the initial first parameter 410 is input into the adjustment module 421, and the adjustment module 421 outputs a set of optional actions; then the initial first parameter 410 and the set of optional actions are input into the optimal action determination module 422, and the optimal action determination module 422 may output an optimal optional action 423. The parameter determination module 710 may use the value corresponding to the optimal optional action 423 output by the optimal action determination module 422 as the output of the reinforcement learning model 420, namely the target first parameter 430.

The adjustment module 421 may include an optional action determination submodule 421-1, a state determination submodule 421-2, and a reward determination submodule 421-3. During a prediction process of the reinforcement learning model 420, the adjustment module may determine the set of optional actions based on the initial first parameter 410 through the optional action determination submodule 421-1. It is worth noting that the target first parameter 430, which is finally determined by adjusting the initial first parameter 410 through the set of optional actions, should not exceed the correction range of the initial first parameter 410. The aforementioned correction range refers to a range for correcting the initial first parameter. It may be understood that, because the various initial first parameters have different types, the correction range corresponding to each initial first parameter may be different. The aforementioned correction range may be preset based on experience.

During a training process of the reinforcement learning model 420, the state determination submodule 421-2 and the reward determination submodule 421-3 in the adjustment module 421 may be respectively used to determine the first parameter of a next state and the reward value.

The optional action determination submodule 421-1 may determine the set of optional actions in a current state based on the first parameter of the current state (e.g., during initial execution, the first parameter of the current state may be the initial first parameter 410). The set of optional actions refers to a set of actions that may be performed on the first parameter of the current state in a certain state; it is worth noting that the adjusted first parameter should not exceed the correction range corresponding to the initial first parameter.

The state determination submodule 421-2 may determine the first parameter of the next state based on the first parameter of the current state and the optimal optional action 423 output by the optimal action determination module 422.

The reward determination submodule 421-3 may be used to determine the reward value. The reward value may be used to determine the accuracy of the adjusted first parameter. For example, for an action with high accuracy, the reward value may be higher; for low accuracy or a negative improvement, the reward value may be lower. The reward value may be represented by a numerical value or other manners. In some embodiments, the reward value of the reinforcement learning model may be related to furnace interior information of the crystal growth apparatus. Taking the first parameter as the electrical conductivity and furnace interior information as the furnace internal temperature as examples, the parameter determination module 710 may input the adjusted first parameter into the simulation model, and an output of the simulation model may be the simulated temperature of the crystal growth apparatus corresponding to the currently adjusted first parameter; the aforementioned simulated temperature is compared with the furnace internal temperature of the crystal growth apparatus, thereby determining the reward value of the adjusted first parameter. The aforementioned reward value may be determined based on a temperature difference value between the simulated temperature and the furnace internal temperature of the crystal growth apparatus and a preset reward rule, wherein the smaller the aforementioned temperature difference value, the greater the reward value. The simulation model may be obtained by training through historical data of the crystal growth apparatus.

The optimal action determination module 422 may determine the optimal optional action 423 based on the first parameter of the current state and the set of optional actions. In some embodiments, the optimal action determination module 422 may be a machine learning model, which may be implemented by various manners, such as a deep neural network (DNN), a convolutional neural network (CNN), a recurrent neural network (RNN), or the like.

In some embodiments, the optimal action determination module 422 may be obtained by training a plurality of groups of third training samples with third training labels based on the reinforcement learning manner, such as a Deep Q-Learning Network (DQN), a Double Deep Q-Learning Network (DDQN), or the like. Third training samples may be the historical first parameters of the crystal growth apparatus, and the third training label is the optimal optional action corresponding to the historical first parameters. The third training sample may be obtained based on historical data of the crystal growth apparatus, and the third training label may be obtained through the reinforcement learning manner.

In some embodiments, the parameter determination module 710 may periodically execute the reinforcement learning model 420 and output the optimal optional action 423 based on a preset trigger condition. For example, if the preset trigger condition is that the crystal growth apparatus executes once per batch, the parameter determination module 710 may determine the optimal optional action 423 output by the reinforcement learning model 420 in the target batch as the target first parameter of the target batch.

Some embodiments of the present disclosure, by processing the initial first parameter through the reinforcement learning model, may more accurately determine the target first parameter and improve the accuracy of the determined simulated crystal surface temperature.

FIG. 5 is a flowchart illustrating an exemplary process for determining the target first parameter according to some embodiments of the present disclosure. In some embodiments, the process 500 may be performed by the parameter determination module 710. As shown in FIG. 5, the process 500 may include the following steps.

In 510, the historical first parameters of the crystal growth apparatus in the plurality of historical batches and the historical working condition parameters corresponding to the historical first parameters are acquired.

The historical batch refers to a batch of crystal growth performed by the crystal growth apparatus before the target batch. Correspondingly, the historical first parameter refers to the first parameter of the crystal growth apparatus in a historical batch.

The historical working condition parameter refers to a parameter related to working conditions of the crystal growth apparatus in a historical batch.

In some embodiments, the historical working condition parameters may include the second temperature detection value of the second temperature measuring point of the crystal growth apparatus in the plurality of historical batches. The second temperature measuring point may refer to a position where the furnace internal temperature is detected by the crystal growth apparatus in the plurality of historical batches, and the second temperature detection value may refer to a result obtained by the crystal growth apparatus detecting the temperature at the second temperature measuring point in the plurality of historical batches. The second temperature measuring point may be the same as or different from the position of the first temperature measuring point described above.

In some embodiments, the historical working condition parameters may further include a historical growth duration of crystal growth of the crystal growth apparatus in the historical batches. The historical growth duration refers to a duration of crystal growth used by the crystal growth apparatus in the plurality of historical batches.

In some embodiments, the historical working condition parameters may further include other parameters. For example, the historical working condition parameters may further include but are not limited to the furnace internal power, the furnace internal pressure, the exhaust rate, the furnace internal power, or the like of the historical batches.

The parameter determination module 710 may acquire the historical first parameters of the crystal growth apparatus in the plurality of historical batches and the historical working condition parameters corresponding to the historical first parameters through historical data of the crystal growth apparatus. Illustratively, the crystal growth apparatus may further include a storage module. Each time the crystal growth apparatus performs crystal growth, it may detect relevant data, for example, detecting the historical first parameters and the historical working condition parameters, and store them as the historical data in the aforementioned storage module. When needed, the parameter determination module 710 may acquire the historical first parameters of the crystal growth apparatus in the plurality of historical batches and the historical working condition parameters corresponding to the historical first parameters from the aforementioned storage module.

In 520, the target first parameter is determined based on the historical first parameters and the historical working condition parameters of the plurality of historical batches.

In some embodiments, when the historical working condition parameters include the second temperature detection values of the second temperature measuring point of the crystal growth apparatus in the plurality of historical batches, the parameter determination module 710 may perform analysis and processing based on the historical first parameters and the second temperature detection values of the plurality of historical batches to determine a second correspondence relationship between the temperature detection value of the second temperature measuring point and the first parameter. The aforementioned second correspondence relationship may reflect a correspondence relationship between the temperature detection value of the second temperature measuring point of the crystal growth apparatus and the first parameter. The second correspondence relationship may be characterized as a fitting function, a machine learning model, or the like. It may be understood that, when the first parameter includes a plurality of types, the second correspondence relationship may include a correspondence relationship between each type of the first parameter and the temperature detection value of the second temperature measuring point. For example, when the first parameter includes the heat transfer coefficient and the electrical conductivity of the crucible, the aforementioned second correspondence relationship may include a correspondence relationship between the temperature detection value of the second temperature measuring point and the heat transfer coefficient and the electrical conductivity of the crucible.

In some embodiments, the parameter determination module 710 may acquire the third temperature detection value of the second temperature measuring point of the crystal growth apparatus in the target batch, and determine the target first parameter based on the third temperature detection value and the second correspondence relationship. The third temperature detection value refers to a result obtained by the crystal growth apparatus performing temperature detection at the second temperature measuring point in the target batch. It may be understood that, when the first temperature measuring point and the second temperature measuring point are the same, the third temperature detection value is the first temperature detection value. The parameter determination module 710 may determine the first parameter corresponding to the third temperature detection value based on the second correspondence relationship, and determine it as the target first parameter.

In some embodiments, when the historical working condition parameters include the historical growth duration of crystal growth of the crystal growth apparatus in the historical batches, the parameter determination module 710 may determine the third correspondence relationship based on the historical first parameters of the plurality of historical batches, a plurality of historical relevant parameters, and a plurality of historical growth durations. The aforementioned third correspondence relationship may reflect a correspondence relationship between a growth duration of a crystal and the first parameter. The third correspondence relationship may be characterized as a fitting function, a machine learning model, or the like. Similar to the second correspondence relationship, when the first parameter includes a plurality of types, the third correspondence relationship may include a correspondence relationship between each type of the first parameter and a growth duration of a crystal.

In some embodiments, the parameter determination module 710 may acquire the target growth duration of crystal growth of the crystal growth apparatus in the target batch; and determine the target first parameter based on the target growth duration and the third correspondence relationship. The parameter determination module 710 may determine the first parameter corresponding to the target growth duration based on the third correspondence relationship, and determine it as the target first parameter.

In some embodiments, the parameter determination module 710 may further establish a parameter prediction model based on the historical first parameters and the historical working condition parameters of the plurality of historical batches; determine a preset working condition parameter of the crystal growth apparatus in the target batch; and determine the target first parameter based on the preset working condition parameter and the parameter prediction model.

The preset working condition parameter may refer to pre-determined working condition parameters in the target batch. The preset working condition parameters may include but are not limited to the pre-determined furnace internal temperature, the furnace internal pressure, the exhaust rate, the furnace internal power, or the like, of various time periods of the crystal growth apparatus in the target batch. The parameter determination module 710 or a user may plan the growth condition of the target batch based on crystal growth information, thereby determining the preset working condition parameters of the crystal growth apparatus in the target batch. More descriptions regarding the crystal growth information may be found elsewhere in the present disclosure (e.g., FIG. 2 and related descriptions thereof).

In some embodiments, the parameter determination module 710 may input the preset working condition parameters of the target batch to the parameter prediction model, and the output of the parameter prediction model is the first parameter under the preset working condition parameters. The parameter determination module 710 may determine the first parameter under the preset working condition parameters as the target parameter. The parameter prediction model may be a machine learning model. For example, the parameter prediction model may include but is not limited to one or a plurality of combinations of a CNN model, a deep learning model, and a random forest model. Some embodiments of the present disclosure may quickly and accurately determine the first parameter by means of the parameter prediction model, thereby improving processing efficiency.

The parameter determination module 710 may train an initial parameter prediction model based on a plurality of groups of the fourth training samples with the fourth training labels, thereby obtaining a trained parameter prediction model. For each group of the fourth training samples with the fourth training labels, the fourth training sample may include the historical working condition parameters of a certain historical batch, and the fourth training label may include the historical first parameters corresponding to the historical batch.

Some embodiments of the present disclosure analyze and process the historical first parameters and the historical working condition parameters of the crystal growth apparatus in the plurality of historical batches, thereby determining the first parameter, and thus more accurately determining the first parameter of the crystal growth apparatus in the target batch, avoiding direct determination based on the initial first parameter, which may cause an error in determining the crystal surface temperature.

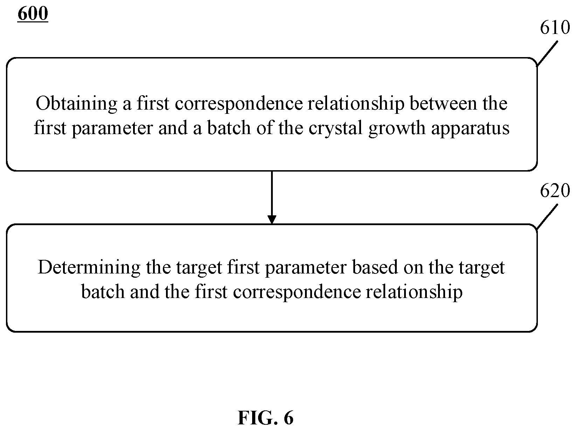

FIG. 6 is another flowchart illustrating an exemplary process for determining the target first parameter according to some embodiments of the present disclosure. In some embodiments, the process 600 may be executed by the parameter determination module 710. As shown in FIG. 6, the process 600 may include the following steps.

In 610, a first correspondence relationship between batches of the crystal growth apparatus and the first parameter is acquired.

In some embodiments, for each of a plurality of preset batches of the crystal growth apparatus, the parameter determination module 710 may determine a reference first parameter corresponding to each preset batch by processing the initial first parameter based on a reinforcement learning model. The plurality of preset batches may refer to a plurality of batches preset by the crystal growth apparatus. For example, the plurality of preset batches may be the first 20 batches of the crystal growth apparatus. The reference first parameter is the first parameter of the crystal growth apparatus in the preset batch. More descriptions regarding the reinforcement learning model may be found elsewhere in the present disclosure (e.g., FIG. 3 and related descriptions thereof).

The parameter determination module 710 may determine the first correspondence relationship between batches of the crystal growth apparatus and the first parameter based on the reference first parameters corresponding to the plurality of preset batches. Similar to the second correspondence relationship and the third correspondence relationship, the first correspondence relationship may also be represented by a fitting function or a machine learning model, or the like. For example, the parameter determination module 710 may perform data fitting on the reference first parameters corresponding to the plurality of preset batches, determine a fitting function between batches of the crystal growth apparatus and the first parameter, and determine the aforementioned fitting function as the first correspondence relationship. For example, the parameter determination module 710 uses a preset batch as a fifth training sample, uses a reference first parameter corresponding to the preset batch as a fifth training label, performs training based on the aforementioned fifth training sample and the fifth training label, determines a machine learning model, and determines the aforementioned machine learning model as the first correspondence relationship.

In 620, the target first parameter is determined based on the target batch and the first correspondence relationship.

For example, when the first correspondence relationship is a fitting function, the parameter determination module 710 may determine the target first parameter based on the target batch by calculation. For example, when the first correspondence relationship is a machine learning model, the parameter determination module 710 may determine the target first parameter by inputting the target batch into the aforementioned machine learning model, an output of which is the target first parameter.

Some embodiments of the present disclosure determine the target first parameter through the first correspondence relationship, avoiding the amount of calculation associated with continuous processing based on a reinforcement learning model, and thereby improving the calculation efficiency of the system for crystal growth 700 while ensuring the accuracy of the target first parameter.

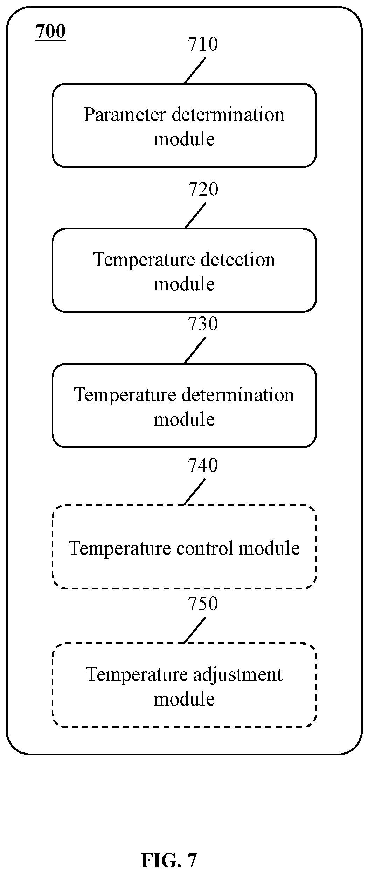

FIG. 7 is an exemplary module diagram illustrating a system for crystal growth according to some embodiments of the present disclosure.

As shown in FIG. 7, the system for crystal growth 700 may include a parameter determination module 710, a temperature detection module 720, and a temperature determination module 730.

The parameter determination module 710 may be configured to determine a parameter set of the crystal growth apparatus in the target batch, wherein the parameter set includes at least one target parameter, and the target parameter is a parameter that affects crystal growth in the crystal growth apparatus. In some embodiments, the target parameter comprises a target first parameter and a target second parameter, the target first parameter comprises a first parameter of a preset object in the crystal growth apparatus in the target batch, the first parameter reflecting a material physical property of the preset object related to crystal growth, the target second parameter comprises a second parameter of the crystal growth apparatus in the target batch, the second parameter comprising a parameter related to a relevant setting of the crystal growth apparatus.

In some embodiments, the parameter determination module 710 may be further configured to acquire an initial first parameter, wherein the initial first parameter reflects the first parameter of the preset object in the crystal growth apparatus in an initial environment; process the initial first parameter based on a reinforcement learning model to determine the target first parameter, wherein a reward value of the reinforcement learning model is related to furnace interior information of the crystal growth apparatus.

In some embodiments, the parameter determination module 710 may be further configured to acquire a first correspondence relationship between batches of the crystal growth apparatus and the first parameter; determine the target first parameter based on the target batch and the first correspondence relationship.

In some embodiments, the parameter determination module 710 may be further configured to: for each of a plurality of preset batches of the crystal growth apparatus, process an initial first parameter based on a reinforcement learning model to determine a reference first parameter corresponding to the preset batch, wherein the initial first parameter reflects the first parameter of the preset object in the crystal growth apparatus in an initial environment, the reference first parameter is the first parameter of the crystal growth apparatus in the preset batch, and a reward value of the reinforcement learning model is related to furnace interior information of the crystal growth apparatus; determine a first correspondence relationship between batches of the crystal growth apparatus and the first parameter based on the reference first parameters corresponding to the plurality of preset batches.

In some embodiments, the parameter determination module 710 may be further configured to acquire historical first parameters of the crystal growth apparatus in a plurality of historical batches and historical working condition parameters corresponding to the historical first parameters, wherein the historical first parameters comprise the first parameter reflecting the preset object in the crystal growth apparatus in the historical batches; determine the target first parameter based on the historical first parameters of the plurality of historical batches and the historical working condition parameters. In some embodiments, the historical working condition parameters comprise a second temperature detection value of a second temperature measuring point of the crystal growth apparatus in the plurality of historical batches, the parameter determination module 710 may be further configured to: determine a second correspondence relationship based on the historical first parameters of the plurality of historical batches and the second temperature detection values, wherein the second correspondence relationship reflects a correspondence relationship between temperature detection values of the second temperature measuring point of the crystal growth apparatus and the first parameter; acquire a third temperature detection value of the second temperature measuring point of the crystal growth apparatus in the target batch; determine the target first parameter based on the third temperature detection value and the second correspondence relationship. In some embodiments, the historical working condition parameters comprise a historical growth duration of crystal growth of the crystal growth apparatus in the historical batches, the parameter determination module 710 may be further configured to: determine a third correspondence relationship based on the historical first parameters of the plurality of historical batches and the historical growth durations, wherein the third correspondence relationship reflects a correspondence relationship between growth durations of crystals and the first parameter; acquire a target growth duration of crystal growth of the crystal growth apparatus in the target batch; determine the target first parameter based on the target growth duration and the third correspondence relationship. In some embodiments, the parameter determination module 710 may be further configured to: establish a parameter prediction model based on the historical first parameters of the plurality of historical batches and the historical working condition parameters; determine a preset working condition parameter of the crystal growth apparatus in the target batch; determine the target first parameter based on the preset working condition parameter and the parameter prediction model.

In some embodiments, the parameter determination module 710 may be further configured to acquire a plurality of groups of reference data, each group of the reference data comprising a plurality of candidate first parameters and validation information corresponding to the plurality of candidate first parameters, each candidate first parameter reflecting a material physical property of the preset object in the crystal growth apparatus; process the plurality of groups of reference data through an importance analysis model to determine a type of the first parameter, the importance analysis model being a random forest model.

The temperature detection module 720 may be configured to acquire a first temperature detection value of a first temperature measuring point of the crystal growth apparatus in a target time period of the target batch.

The temperature determination module 730 may be configured to determine, based on the target parameter and the first temperature detection value, a simulated crystal surface temperature corresponding to the first temperature detection value through a crystal surface temperature determination model.

In some embodiments, the system for crystal growth 700 shown in FIG. 7 may further include a temperature control module 740. The aforementioned temperature control module 740 may be configured to determine, based on the simulated crystal surface temperature, a temperature control parameter of the crystal growth apparatus in the target time period of the target batch. In some embodiments, the temperature control module 740 may be further configured to acquire a plurality of reference crystal surface temperatures of each of a plurality of reference apparatuses in a reference batch and a plurality of reference control parameters corresponding to the plurality of reference crystal surface temperatures, wherein the reference apparatus is an apparatus of the same type as the crystal growth apparatus; determine the temperature control parameter based on the reference crystal surface temperatures of the plurality of reference apparatuses in the reference batch, the reference control parameters, and the simulated crystal surface temperature. In some embodiments, the temperature control module 740 may be further configured to acquire crystal detection data of crystals generated by the plurality of reference apparatuses in the reference batch; determine the temperature control parameter based on the reference crystal surface temperatures of the plurality of reference apparatuses in the reference batch, the reference control parameters, the crystal detection data, and the simulated crystal surface temperature.

In some embodiments, the system for crystal growth 700 shown in FIG. 7 may further include a temperature adjustment module 750. The aforementioned temperature adjustment module 750 may be configured to automatically send a temperature adjustment instruction based on the temperature control parameter, so as to adjust a crystal growth temperature of the crystal growth apparatus in the target time period of the target batch.

It should be understood that the system for crystal growth 700 shown in FIG. 7 and its modules may be implemented in various manners. Merely by way of example, the system for crystal growth 700 may be applied to a processor of a crystal growth apparatus. The crystal growth apparatus may further include a crystal growth device. The aforementioned processor may control the crystal growth device through the aforementioned system for crystal growth 700, to implement the method for crystal growth described in any one of the following embodiments of the present disclosure.

It should be noted that the above descriptions of the system for crystal growth 700 and its modules are merely for convenience of description, and should not limit the present disclosure to the scope of the exemplary embodiments. It may be understood that for a person skilled in the art, after understanding the principle of the system, the various modules may be arbitrarily combined, or subsystems may be formed and connected with other modules, without departing from the principle. In some embodiments, the parameter determination module 710, the temperature detection module 720, and the temperature determination module 730 disclosed in FIG. 7 may be different modules in a system, or a module may implement the functions of two or more of the aforementioned modules. For example, the various modules may share a storage module, or the various modules may also respectively have their own storage modules. Such variations are all within the protection scope of the present disclosure.

The basic concepts have been described above. It will be apparent to a person skilled in the art that the foregoing detailed disclosure is provided merely by way of example and is not intended to limit the present disclosure. Although not expressly stated herein, a person skilled in the art may make various modifications, improvements, and alterations to the present disclosure. Such modifications, improvements, and alterations are suggested in the present disclosure, and therefore, such modifications, improvements, and alterations still fall within the spirit and scope of the exemplary embodiments of the present disclosure.

Furthermore, the present disclosure uses specific terms to describe the embodiments of the present disclosure. Terms such as 'an embodiment,' 'one embodiment,' and/or 'some embodiments' refer to a particular feature, structure, or characteristic related to at least one embodiment of the present disclosure. Accordingly, it should be emphasized and noted that the phrases 'an embodiment,' 'one embodiment,' or 'an alternative embodiment,' when referred to two or more times in different locations in the present disclosure, do not necessarily refer to the same embodiment. Further, certain features, structures, or characteristics of one or a plurality of embodiments of the present disclosure may be combined appropriately.

Moreover, unless explicitly stated in the claims, the order of process elements and sequences, the use of numerals or letters, or the use of other names described in the present disclosure is not intended to limit the order of the processes and manners of the present disclosure. While some embodiments of the present disclosure currently considered useful have been discussed in the foregoing disclosure through various examples, it should be understood that such details are merely for illustrative purposes, and the appended claims are not limited to the disclosed embodiments. Rather, the claims are intended to cover all modifications and equivalent combinations that fall within the spirit and scope of the embodiments of the present disclosure. For example, although the system components described above may be implemented by hardware devices, the components may also be implemented solely by software solutions, such as by installing the described system on an existing server or mobile device.

Similarly, it should be noted that for the purpose of simplifying the expression of the disclosure of the present disclosure, thereby facilitating the understanding of one or a plurality of embodiments of the present disclosure, the descriptions of the embodiments of the present disclosure in the preceding descriptions may sometimes group a plurality of features into a single embodiment, figure, or description thereof. However, this manner of disclosure does not mean that the subject matter of the present disclosure requires more features than those recited in the claims. Indeed, the features of an embodiment may be fewer than all the features of a single embodiment described above.

In some embodiments, numbers describing the quantity of ingredients and properties are used. It should be understood that such numbers used in the description of embodiments are, in some instances, modified by the terms "about," "approximate," or "substantially." Unless otherwise stated, "about," "approximate," or "substantially" indicates that the stated number allows for a variation of ±20%. Accordingly, in some embodiments, the numerical parameters used in the specification and claims are approximations, which may change according to the required characteristics of individual embodiments. In some embodiments, numerical parameters should consider the specified significant digits and apply standard rounding methods. Although the numerical ranges and parameters used to confirm the breadth of the scope in some embodiments of this specification are approximations, in specific embodiments, such numerical values are set as precisely as possible within the feasible range.

Each patent, patent application, patent application publication, and other materials (such as articles, books, manuals, publications, documents, etc.) cited in this specification is hereby incorporated by reference in its entirety. Excepted are prosecution history documents that are inconsistent or in conflict with the content of this specification, and documents that limit the broadest scope of the claims of this specification (now or later appended to this specification). It should be noted that if there is any inconsistency or conflict between the descriptions, definitions, and/or use of terms in the supplementary materials of this specification and the content described herein, the descriptions, definitions, and/or use of terms in this specification shall prevail.

Finally, it should be understood that the embodiments described in this specification are only used to illustrate the principles of the embodiments of this specification. Other variations may also fall within the scope of this specification. Therefore, by way of example and not limitation, alternative configurations of the embodiments of this specification may be considered consistent with the teachings herein. Accordingly, the embodiments of this specification are not limited to those explicitly introduced and described in this specification.

## Claims

1. A method for crystal growth, comprising:
determining a parameter set of a crystal growth apparatus in a target batch, wherein the parameter set includes at least one target parameter, and the target parameter is a parameter that affects crystal growth in the crystal growth apparatus;
obtaining, in a target time period of the target batch, a first temperature detection value of a first temperature measuring point of the crystal growth apparatus; and
determining, based on the target parameter and the first temperature detection value, a simulated crystal surface temperature corresponding to the first temperature detection value through a crystal surface temperature determination model.

2. The method according to claim 1, further comprising:
determining, based on the simulated crystal surface temperature, a temperature control parameter of the crystal growth apparatus in the target time period of the target batch.

3. The method according to claim 2, further comprising:
automatically sending a temperature adjustment instruction based on the temperature control parameter to adjust a crystal growth temperature of the crystal growth apparatus in the target time period.

4. The method according to claim 1, wherein the target parameter includes a target first parameter and a target second parameter;
the target first parameter includes a first parameter of a preset object in the crystal growth apparatus in the target batch, the first parameter reflecting a material physical property of the preset object related to crystal growth; and
the target second parameter includes a second parameter of the crystal growth apparatus in the target batch, the second parameter including a parameter related to a relevant setting of the crystal growth apparatus.

5. The method according to claim 4, wherein the material physical property includes at least one of a heat transfer coefficient, an electrical conductivity, a surface emissivity, a thermal conductivity, a specific heat capacity at constant pressure, and a relative permeability.

6. The method according to claim 4, wherein the preset object includes at least one of a crucible, a thermal insulation felt, a raw material melt, and a protective gas.

7. The method according to claim 4, wherein the determining a parameter set of a crystal growth apparatus in a target batch includes:
obtaining an initial first parameter, wherein the initial first parameter reflects the first parameter of the preset object in the crystal growth apparatus in an initial environment; and
determining the target first parameter by processing, based on a reinforcement learning model, the initial first parameter, wherein a reward value of the reinforcement learning model is related to furnace interior information of the crystal growth apparatus.

8. The method according to claim 4, wherein the determining a parameter set of a crystal growth apparatus in a target batch includes:
obtaining a first correspondence relationship between the first parameter and a batch of the crystal growth apparatus; and
determining the target first parameter based on the target batch and the first correspondence relationship.

9. The method according to claim 8, wherein the first correspondence relationship is determined through operations including:
for each of a plurality of preset batches of the crystal growth apparatus, determining a reference first parameter corresponding to the preset batch by processing, based on a reinforcement learning model, an initial first parameter, wherein the initial first parameter reflects the first parameter of the preset object in the crystal growth apparatus in an initial environment, the reference first parameter is the first parameter of the crystal growth apparatus in the preset batch, and a reward value of the reinforcement learning model is related to furnace interior information of the crystal growth apparatus; and
determining the first correspondence relationship between the first parameter and the batch of the crystal growth apparatus based on the reference first parameters corresponding to the plurality of preset batches.

10. The method according to claim 4, wherein the determining a parameter set of a crystal growth apparatus in a target batch includes:
obtaining historical first parameters of the crystal growth apparatus in a plurality of historical batches and historical working condition parameters corresponding to the historical first parameters, wherein the historical first parameters include the first parameter reflecting the preset object in the crystal growth apparatus in the plurality of historical batches; and
determining the target first parameter based on the historical first parameters and the historical working condition parameters of the plurality of historical batches.

11. The method according to claim 10, wherein the historical working condition parameters include second temperature detection values of a second temperature measuring point of the crystal growth apparatus in the plurality of historical batches; and
the determining the target first parameter based on the historical first parameters and the historical working condition parameters of the plurality of historical batches includes:
determining a second correspondence relationship based on the historical first parameters and the second temperature detection values of the plurality of historical batches, wherein the second correspondence relationship reflects a correspondence relationship between the first parameter and a temperature detection value of the second temperature measuring point of the crystal growth apparatus;
obtaining a third temperature detection value of the second temperature measuring point of the crystal growth apparatus in the target batch; and
determining the target first parameter based on the third temperature detection value and the second correspondence relationship.

12. The method according to claim 10, wherein the historical working condition parameters include historical growth durations of crystal growth of the crystal growth apparatus in the plurality of historical batches; and
the determining the target first parameter based on the historical first parameters and the historical working condition parameters of the plurality of historical batches includes:
determining a third correspondence relationship based on the historical first parameters and the historical growth durations of the plurality of historical batches, the third correspondence relationship reflecting a correspondence relationship between the first parameter and a growth duration of a crystal;
obtaining a target growth duration of crystal growth of the crystal growth apparatus in the target batch; and
determining the target first parameter based on the target growth duration and the third correspondence relationship.

13. The method according to claim 10, wherein the determining the target first parameter based on the historical first parameters and the historical working condition parameters of the plurality of historical batches includes:
establishing a parameter prediction model based on the historical first parameters and the historical working condition parameters of the plurality of historical batches;
determining a preset working condition parameter of the crystal growth apparatus in the target batch; and
determining the target first parameter based on the preset working condition parameter and the parameter prediction model.

14. The method according to claim 4, wherein a type of the first parameter is determined through operations including:
obtaining a plurality of sets of reference data, each set of the reference data including a plurality of candidate first parameters and validation information corresponding to the plurality of candidate first parameters, each of the candidate first parameters reflecting the material physical property of the preset object in the crystal growth apparatus; and
determining the type of the first parameter by processing the plurality of sets of reference data through an importance analysis model, the importance analysis model being a random forest model.

15. The method according to claim 2, wherein the determining, based on the simulated crystal surface temperature, a temperature control parameter of the crystal growth apparatus in the target time period of the target batch includes:
obtaining a plurality of reference crystal surface temperatures of each of a plurality of reference apparatuses in a reference batch and a plurality of reference control parameters corresponding to the plurality of reference crystal surface temperatures, wherein the plurality of reference apparatuses are apparatuses of the same type as the crystal growth apparatus; and
determining the temperature control parameter based on the reference crystal surface temperatures, the reference control parameters of the plurality of reference apparatuses in the reference batch, and the simulated crystal surface temperature.

16. The method according to claim 15, wherein the determining the temperature control parameter based on the reference crystal surface temperatures, the reference control parameters of the plurality of reference apparatuses in the reference batch, and the simulated crystal surface temperature includes:
obtaining crystal detection data of crystals generated by the plurality of reference apparatuses in the reference batch; and
determining the temperature control parameter based on the reference crystal surface temperatures, the reference control parameters of the plurality of reference apparatuses in the reference batch, the crystal detection data, and the simulated crystal surface temperature.

17. A system for crystal growth, comprising:
a parameter determination module, configured to determine a parameter set of a crystal growth apparatus in a target batch, wherein the parameter set includes at least one target parameter, and the target parameter is a parameter that affects crystal growth in the crystal growth apparatus;
a temperature detection module, configured to obtain a first temperature detection value of a first temperature measuring point of the crystal growth apparatus in a target time period of the target batch; and
a temperature determination module, configured to determine, based on the target parameter and the first temperature detection value, a simulated crystal surface temperature corresponding to the first temperature detection value through a crystal surface temperature determination model.

18. The system according to claim 17, further comprising:
a temperature control module, configured to determine, based on the simulated crystal surface temperature, a temperature control parameter of the crystal growth apparatus in the target time period of the target batch.

19. The system according to claim 17, further comprising:
a temperature adjustment module, configured to automatically send a temperature adjustment instruction based on the temperature control parameter, so as to adjust a crystal growth temperature of the crystal growth apparatus in the target time period of the target batch.

20. The system according to claim 17, wherein the target parameter comprises a target first parameter and a target second parameter;
the target first parameter comprises a first parameter of a preset object in the crystal growth apparatus in the target batch, the first parameter reflecting a material physical property of the preset object related to crystal growth; and
the target second parameter comprises a second parameter of the crystal growth apparatus in the target batch, the second parameter comprising a parameter of a relevant setting of the crystal growth apparatus.

21. The system according to claim 20, wherein the parameter determination module is further configured to:
obtain an initial first parameter, wherein the initial first parameter reflects the first parameter of the preset object in the crystal growth apparatus in an initial environment; and
process the initial first parameter based on a reinforcement learning model to determine the target first parameter, wherein a reward value of the reinforcement learning model is related to furnace interior information of the crystal growth apparatus.

22. The system according to claim 20, wherein the parameter determination module is further configured to:
obtain a first correspondence relationship between batches of the crystal growth apparatus and the first parameter; and
determine the target first parameter based on the target batch and the first correspondence relationship.

23. The system according to claim 22, wherein the parameter determination module is further configured to:
for each of a plurality of preset batches of the crystal growth apparatus, process an initial first parameter based on a reinforcement learning model to determine a reference first parameter corresponding to the preset batch, wherein the initial first parameter reflects the first parameter of the preset object in the crystal growth apparatus in an initial environment, the reference first parameter is the first parameter of the crystal growth apparatus in the preset batch, and a reward value of the reinforcement learning model is related to furnace interior information of the crystal growth apparatus; and
determine a first correspondence relationship between the first parameter and a batch of the crystal growth apparatus based on the reference first parameters corresponding to the plurality of preset batches.

24. The system according to claim 20, wherein the parameter determination module is further configured to:
obtain historical first parameters of the crystal growth apparatus in a plurality of historical batches and historical working condition parameters corresponding to the historical first parameters, wherein the historical first parameters comprise the first parameter reflecting the preset object in the crystal growth apparatus in the plurality of historical batches; and
determine the target first parameter based on the historical first parameters of the plurality of historical batches and the historical working condition parameters.

25. The system according to claim 24, wherein the historical working condition parameters comprise second temperature detection values of a second temperature measuring point of the crystal growth apparatus in the plurality of historical batches; and
the parameter determination module is further configured to:
determine a second correspondence relationship based on the historical first parameters of the plurality of historical batches and the second temperature detection values, wherein the second correspondence relationship reflects a correspondence relationship between the first parameter and a temperature detection value of the second temperature measuring point of the crystal growth apparatus;
obtain a third temperature detection value of the second temperature measuring point of the crystal growth apparatus in the target batch; and
determine the target first parameter based on the third temperature detection value and the second correspondence relationship.

26. The system according to claim 24, wherein the historical working condition parameters comprise historical growth durations of crystal growth of the crystal growth apparatus in the plurality of historical batches; and
the parameter determination module is further configured to:
determine a third correspondence relationship based on the historical first parameters of the plurality of historical batches and the historical growth durations, wherein the third correspondence relationship reflects a correspondence relationship between the first parameter and a growth duration of a crystal;
obtain a target growth duration of crystal growth of the crystal growth apparatus in the target batch; and
determine the target first parameter based on the target growth duration and the third correspondence relationship.

27. The system according to claim 24, wherein the parameter determination module is further configured to:
establish a parameter prediction model based on the historical first parameters of the plurality of historical batches and the historical working condition parameters;
determine a preset working condition parameter of the crystal growth apparatus in the target batch; and
determine the target first parameter based on the preset working condition parameter and the parameter prediction model.

28. The system according to claim 20, wherein the parameter determination module is further configured to:
obtain a plurality of groups of reference data, each group of the reference data comprising a plurality of candidate first parameters and validation information corresponding to the plurality of candidate first parameters, each candidate first parameter reflecting the material physical property of the preset object in the crystal growth apparatus; and
process the plurality of groups of reference data through an importance analysis model to determine a type of the first parameter, the importance analysis model being a random forest model.

29. The system according to claim 18, wherein the temperature control module is further configured to:
obtain a plurality of reference crystal surface temperatures of each of a plurality of reference apparatuses in a reference batch and a plurality of reference control parameters corresponding to the plurality of reference crystal surface temperatures, wherein the reference apparatus is an apparatus of the same type as the crystal growth apparatus; and
determine the temperature control parameter based on the reference crystal surface temperatures of the plurality of reference apparatuses in the reference batch, the reference control parameters, and the simulated crystal surface temperature.

30. The system according to claim 29, wherein the temperature control module is further configured to:
obtain crystal detection data of crystals generated by the plurality of reference apparatuses in the reference batch; and
determine the temperature control parameter based on the reference crystal surface temperatures of the plurality of reference apparatuses in the reference batch, the reference control parameters, the crystal detection data, and the simulated crystal surface temperature.

31. A crystal growth apparatus, comprising a crystal growth device and a processor, wherein the processor is configured to execute the method for crystal growth according to any one of claims 1 to 16.

32. A non-transitory computer-readable storage medium, wherein the storage medium stores computer instructions, and when a computer reads the computer instructions in the storage medium, the computer executes the method for crystal growth according to any one of claims 1 to 16.
